# EUROPEAN PATENT APPLICATION

(11) **EP 1 748 472 A1**
(43) Date of publication of application: **31.01.2007**
(21) Application number: 05112170.5
(22) Date of filing: 14.12.2005
(51) Int. Cl.: H01L 21/28, H01L 29/423, H01L 29/51, G11C 16/04, H01L 29/788, H01L 29/792

(54) **Non-volatile memory transistor**

(30) Priority: 28.07.2005 US 703639 P
(71) Applicant: INTERUNIVERSITAIR MICROELEKTRONICA CENTRUM VZW, 3001 Leuven (BE)
(72) Inventor: Rosmeulen, Maarten, B-3000, Leuven (BE); Govoreanu, Bogdan, B-3010, Leuven (BE); Blomme, Pieter, B-8400, Oostende (BE)
(74) Representative: Sarlet, Steven Renaat Irène

(57) **Abstract**

A non-volatile memory device comprising a charge supply region (1), i.e. a channel region, a charge storage medium (3), an insulating barrier (2) extending between the charge supply region (1) and the charge storage medium (3), and means (5), i.e. a gate, for establishing an electric field over the insulating barrier (2) for tunnelling charge carriers from the charge supply region to the charge storage medium (3). The insulating barrier (2) is a gate insulator and comprises a first portion (21) contacting the charge supply region (1) and a second portion (22) contacting the first portion and extending towards the charge storage medium (3). The first and second portions are each constructed in one or more tunnelling dielectrics, chosen such that the first portion (21) has on average a lower dielectric constant than the second portion (22). The first and second portions have predetermined thicknesses which are determined such that tunnelling of negative as well as positive charge carriers from the charge supply region (1) to the charge storage medium (3) is enabled.

## Description

### TECHNICAL FIELD

This invention relates to non-volatile memory devices. More particularly, in a first aspect the invention relates to a non-volatile memory device in which positive and negative charge carriers are tunnelled through the same insulating barrier and in a second aspect the invention relates to a charge-trapping non-volatile memory device in which the discrete storage sites are spatially distributed.

### BACKGROUND ART

Non-volatile memory (NVM) devices are used in a wide variety of commercial and military electronic devices and equipment, such as e.g. handheld telephones, radios and digital cameras.

NVM devices have for example been disclosed in EP-A-1 253 646, in which a multiple layer insulating barrier is used between the charge supply medium and the charge storage region, the latter being either a floating gate or a charge trapping layer. Programming the device is done by tunnelling a first type of charge carriers, typically electrons, through the insulating barrier towards the charge storage region.

The device known from EP-A-1 253 646 has the disadvantage that, in order to be able to remove the stored charge, either a different route for removing the charge has to be chosen, or the insulating barrier needs to have a symmetric, so a more complex structure, so that the first type of charge carriers can also tunnel through it in opposite direction.

NVM devices that use charge trapping, for example in a charge trapping layer, such as a silicon nitride layer sandwiched between two oxide layers, or in nano-crystals, as a charge storage mechanism instead of a floating gate (FG), are being investigated more and more, since they have considerable potential to be used in future CMOS generations, in particular for the 90 nm node and beyond. One difference between charge trapping devices and floating gate devices is that in charge trapping devices, electrons are trapped in energy minima caused by imperfections in the charge trapping layer, e. g. a silicon nitride layer, or, in the case of nano-crystal memories, on the nano-crystals embedded in a gate oxide. These energy minima act as localized charge storage sites, isolated from each other, in which the charge is trapped and stored.

One reason for the growing interest in charge trapping devices is the good scaling perspective that charge trapping devices comprising a dielectric charge trapping layer offer, eliminating for instance FG patterning issues, such as lithography, overlay and topography. Moreover, they can be programmed and erased with lower voltages than FG devices, which is a very important point, especially in embedded memories, as the market continues to demand devices with lower operating voltages and lower power consumption. A third advantage is the excellent program/erase endurance, which is about two orders of magnitude better than what can be reached with FG devices.

A major disadvantage of charge trapping devices is their limited data retention, which is a result of the use of thin dielectrics between the substrate and the charge trapping layer. Data retention is the ability of an NVM to retain data. Use of a thicker conventional tunnel dielectric, e.g. Si02, would improve the retention behaviour at the expense of worsened erase saturation and, consequently, the program/erase window of a conventional charge trapping device. The erase saturation is the inability to completely remove or compensate for the charge stored in the charge storage medium after programming the charge trapping device.

### DISCLOSURE OF THE INVENTION

It is a first aim of the invention to provide a non-volatile memory device with which programming and erasing can be performed through the same insulating barrier without increasing the complexity of its structure.

This first aim is achieved with the device showing the technical characteristics of claim 1.

It is a second aim of the invention to provide a charge-trapping non-volatile memory device with improved data retention.

This second aim is achieved with the device showing the technical characteristics of claim 17.

The non-volatile memory device according to the first aspect of the invention comprises a charge supply region, a charge storage medium, an insulating barrier extending between the charge supply region and the charge storage medium, and means for establishing an electric field over the insulating barrier for tunnelling charge carriers from the charge supply region to the charge storage medium. The insulating barrier comprises a first portion contacting the charge supply region and a second portion contacting the first portion and extending towards the charge storage medium. The first portion is substantially thinner than the second portion. The first and second portions are each constructed in one or more tunnelling dielectrics, which are chosen such that the first portion has on average a lower dielectric constant than the second portion. Furthermore, the first and second portions have predetermined thicknesses which are determined such that tunnelling of negative as well as positive charge carriers from the charge supply region to the charge storage medium is enabled.

An analysis of the prior art has shown that the problem is caused by the fact that the insulating barrier is optimised for the tunnelling of one type of charge carriers in one direction only. As a result, in order to be able to remove the stored charge, either a different route for removing the charge has to be chosen, or the insulating barrier needs to have a symmetric, so a more complex structure, for enabling the first or second type of charge carriers to tunnel through it in opposite direction.

In the device of the first aspect of the invention, the insulating barrier is optimised for tunnelling of both negative and positive charge carriers in the same direction, i.e. from the charge supply region to the charge storage region. This means that the materials and the thicknesses of the first and second portions are in fact designed twice, once for tunnelling of the first type of charge carriers from the charge supply region to the charge storage region, and once for tunnelling of the second type of charge carriers from the charge supply region to the charge storage region. From both designs, a common design is extracted which fulfils the requirements for tunnelling of both types of charge carriers from the charge supply region to the charge storage region.

The advantage is that either the structure of the insulating barrier can be simplified, as there is no longer a need to enable tunnelling in the opposite direction, or that removal of the charge from the charge storage region via a different route can be avoided, which would require optimisation of that route to enable tunnelling of the respective type of charge carriers.

In the device of the first aspect of the invention, the charge storage medium can either be a conductive floating gate or a layer of localised charge storage sites isolated from each other, such as for example a charge trapping silicon nitride layer, a charge trapping high-k dielectric layer, a silicon-rich oxide, a dielectric layer embedding small conductive islands isolated from each other. These small conductive islands are preferably made of Si or Ge nanocrystals.

The non-volatile memory device according to the second aspect of the invention comprises a charge supply region, a charge storage medium comprising discrete storage sites isolated from each other, an insulating barrier extending between the charge supply region and the charge storage medium, and means for establishing an electric field over the insulating barrier for tunnelling charge carriers from the charge supply region to the charge storage medium. The insulating barrier comprises a first portion contacting the charge supply region and a second portion contacting the first portion and extending towards the charge storage medium. The first portion is substantially thinner than the second portion. The first and second portions are each constructed in one or more tunnelling dielectrics, which are chosen such that the first portion has on average a lower dielectric constant than the second portion. The discrete storage sites of the charge storage medium are located at variable distances from the charge supply region, so that they are spatially distributed over at least part of the charge storage medium.

As a result of the distribution of the stored charge over isolated storage sites, the memory device of the second aspect of the invention has high immunity with respect to the presence of a localized defect in the insulating barrier. This means that in case of such a localized defect, the charge stored in the discrete storage sites may only leak out of the storage medium locally, due to the storage sites being isolated from each other, as opposed to a conductive storage medium (corresponding to only one big storage site), where the charge is free to move within the entire storage medium and can completely leak out in time via the localized defect, causing loss of information. On top of this, the spatial distribution of the charge in the storage medium, i.e. the fact that the different storage sites are located at variable distances from the charge supply region, provides an additional barrier corresponding to the part of the storage medium between a particular storage site and the insulating barrier. This can further improve the ability of such a non-volatile memory to retain stored information for a longer time.

In the device of the second aspect of the invention, the charge storage medium is a layer of localised charge storage sites isolated from each other, such as for example a charge trapping silicon nitride layer, a charge trapping high-k dielectric layer, a silicon-rich oxide, a dielectric layer embedding small conductive islands isolated from each other. These small conductive islands are preferably made of Si or Ge nanocrystals.

In the following, features and advantages of embodiments of both aspects of the invention are described.

In a preferred embodiment, the thicknesses and the tunnelling dielectrics of the first and second portions are chosen such that upon applying an electric field suitable for tunnelling positive or negative charge carriers through the insulating barrier the applied electric field over the first portion is stronger than the applied electric field over the second portion. This has the advantage that the potential energy barrier upon applying the electric field for tunnelling will show a steeper inclination over the first portion than over the second portion, so that the tunnelling can be effected at low externally applied voltages and, consequently, it may reduce the power consumption.

Furthermore, the thicknesses and the tunnelling dielectrics of the first and second portions are preferably chosen such that upon applying an electric field suitable for tunnelling positive or negative charge carriers through the insulating barrier, the potential energy barrier of the second portion for tunnelling carriers is suppressed more than the potential energy barrier of the first portion for tunnelling. This will increase the tunnelling current necessary to change the logic state of the device, so that the device can be operated at lower externally applied voltages, which can also reduce the power consumption.

In a preferred embodiment of the device of the invention, the electric field establishing means are adapted for applying a voltage drop between the charge supply region and the charge storage medium, and the tunnelling dielectrics and the thicknesses of the first and second portions are chosen such that, upon applying a voltage drop suitable for tunnelling positive, resp. negative charge carriers through the insulating barrier, the potential energy barrier of the second portion for tunnelling positive, resp. negative charge carriers is substantially removed. This can further increase the tunnelling current, optimizing the low voltage operation..

The tunnelling dielectrics are furthermore preferably chosen such that, in absence of an electric field over the insulating barrier, the first portion has a higher potential energy barrier than the second portion, for both negative and positive charge carriers tunnelling from the charge supply region to the charge storage medium. This can enhance data retention of the devices of the invention.

The insulating barrier is preferably constructed as a two-layered structure, with the dielectrics of the first and the second portions preferably being selected from the group comprising: Si02, silicon oxynitride, e.g. SiON, or Si3N4, r Si3N4, Al2O3, Hf02, Hf silicate, e.g. HfSiOx or HfSiON, Hf aluminate, e.g. HfAlOx, ZrO2, Pr2O3, Y2O3, La2O3 or La-aluminate, e.g. LaAlO. The first portion is preferably constructed in a dielectric material with a dielectric constant lower than 15, and the second portion is preferably constructed in a dielectric material with a dielectric constant higher than 7.

The means for establishing a tunnelling current preferably comprise a control region which is located on the opposite side of the charge storage medium with respect to the charge supply region and is separated from the charge storage medium by a second insulating barrier. This second insulating barrier preferably has a predetermined thickness for blocking charge carrier transfer between the control region and the charge storage medium. It is preferably constructed in Si02, Si3N4, Al2O3, Hf02, Hf-silicate, or Hf-aluminate, or a combination of these materials. The control region is preferably constructed in highly doped poly-Si, a metal, or a compound with metallic character. The metal or the compound with metallic character preferably has a work function of 4 eV or higher.

### BRIEF DESCRIPTION OF THE DRAWINGS

Example embodiments are illustrated in referenced figures of the drawings. It is intended that the embodiments and figures disclosed herein are to be considered illustrative rather than restrictive.

Figure 1 is a drawing illustrating a schematic cross-section of a non-volatile memory device.

Figure 2 is a drawing illustrating a schematic representation of the energy band diagram, with illustration of the bottom of the conduction band, Ec, indicative of the potential energy profile for electrons, and of the top of the valence band, Ev, indicative of the potential energy profile for holes, across a bottom-up cross-section of a non-volatile memory device.

Figure 3 is a drawing illustrating a schematic representation of:
(a) a bias set-up for applying external voltages to a non-volatile memory device, and
(b) a potential energy Ec profile for electrons across a bottom-up cross-section of a non-volatile memory device under these externally applied voltages, when programming the memory device. The axis Ee conventionally indicates that increasing electron energies are measured upward.

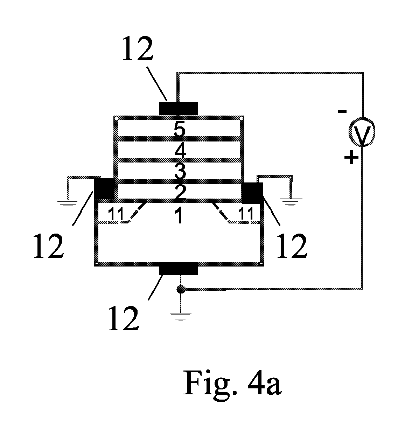

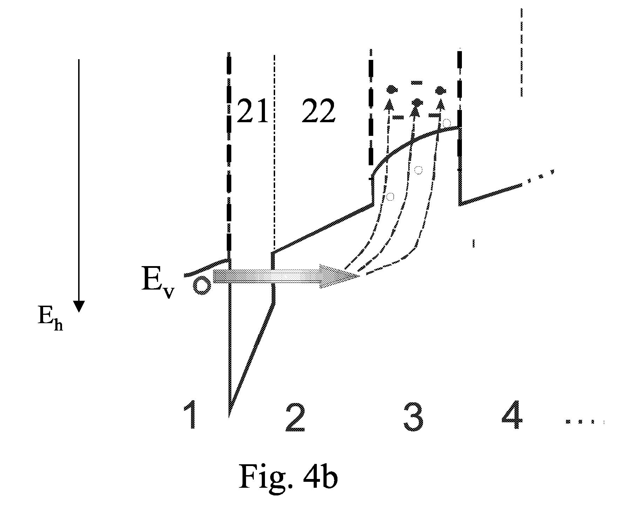

Figure 4 is a drawing illustrating a schematic representation of:
(a) a bias set-up for applying external voltages to a non-volatile memory device, and
(b) a potential energy Ev profile for holes across a bottom-up cross-section of a non-volatile memory device under these externally applied voltages, when erasing the memory device. The axis Eh conventionally indicates that increasing hole energies are measured downward.

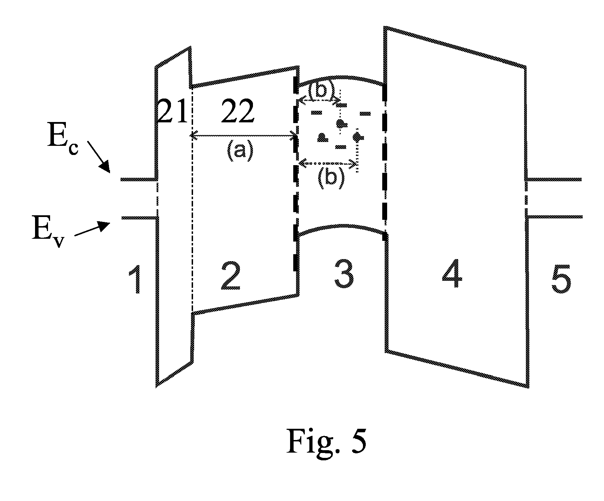

Figure 5 is a drawing illustrating a schematic representation of the energy band diagram of a non-volatile memory device when programmed and in the absence of any external applied voltages.

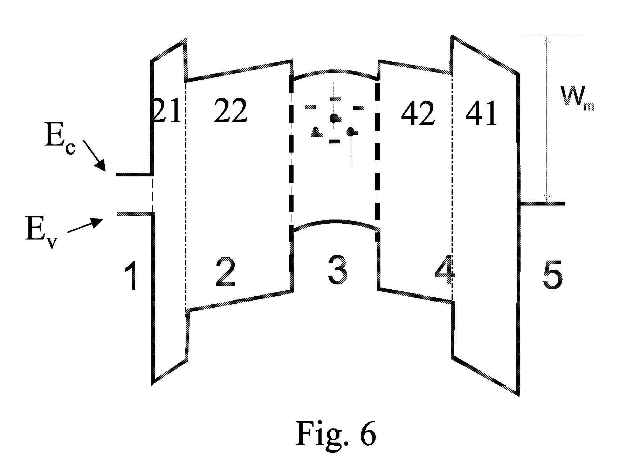

Figure 6 is a drawing illustrating a schematic representation of the energy band diagram of a non-volatile memory device when programmed and in the absence of any external applied voltages, where a low-k/high-k dielectric stack is used for both insulating layers and a metal layer is used for the control region.

### MODES FOR CARRYING OUT THE INVENTION

The devices described below with reference to the drawings provide for non-volatile memory (NVM) devices with which, on the one hand, programming and erasing can be performed through the same insulating barrier without needing a complex structure and, on the other hand, data retention can be improved over existing NVM devices, while maintaining low write/erase operating voltages and, consequently, low power consumption and without compromising device functionality. These two aspects are to be considered independently from each other and alternative embodiments are given below which may only involve one of both aspects.

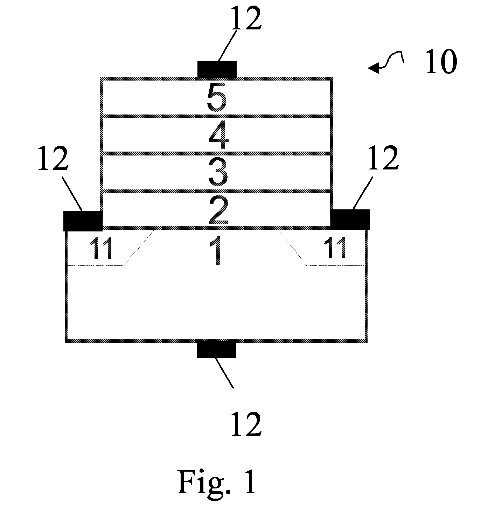

In fig. 1, an embodiment of a non-volatile memory device is shown which comprises a charge supply region 1, a charge storage medium 3 comprising discrete storage sites isolated from each other, an insulating barrier 2 extending between the charge supply region and the charge storage medium. A mechanism 4, 5 is provided for establishing an electric field over the insulating barrier 2 and for establishing a difference in electrochemical potential over the insulating barrier for tunnelling charge carriers (negative or positive, e.g. electrons or holes, respectively) from the charge supply region 1 to the charge storage medium 3. The charge supply region provides charge carriers of opposite polarity, e.g. electrons and holes. The mechanism comprises a control region 5, separated from the charge storage medium 3 by a second insulating region 4, upon which external voltages can be applied, in order to establish an electric field over the first insulating barrier and for establishing a difference in electrochemical potential over the insulating barrier for tunnelling of carriers at least through the insulating barrier 2.

In an alternative embodiment, the charge storage region may also comprise a conductive floating gate. The mechanism for establishing an electric field over the insulating barrier 2 and for establishing a difference in electrochemical potential over the insulating barrier for tunnelling charge carriers may also be carried out in any other way known to the person skilled in the art.

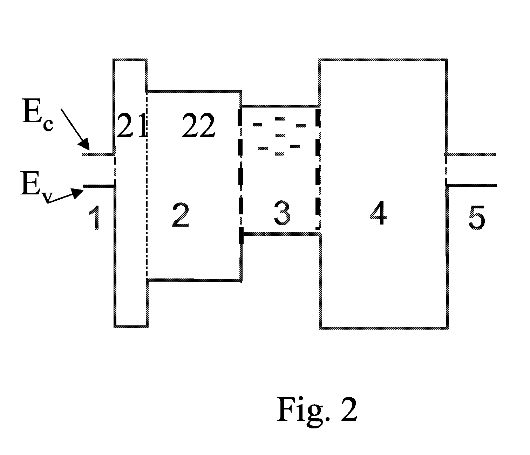

As shown in figure 2, the insulating barrier comprises a first portion 21 contacting the charge supply region and a second portion 22 contacting the first portion and extending towards the charge storage medium 3. Alternatively, the insulating barrier 2 may comprise a third portion in between the second portion and the charge storage medium. The first portion 21 is substantially thinner than the second portion 22. The first and second portions can each be constructed in one or more tunnelling dielectrics. The thickness of the first and second portions and their tunnelling dielectrics are chosen such that upon applying an electric field which is sufficient for establishing a tunnelling current through the insulating barrier, the potential energy barrier of the second portion 22 is suppressed more than the potential energy barrier of the first portion 21, or substantially removed. The discrete storage sites of the charge storage medium 3 are located at variable distances from the charge supply region 1, so that they are spatially distributed over at least part of the charge storage medium 3.

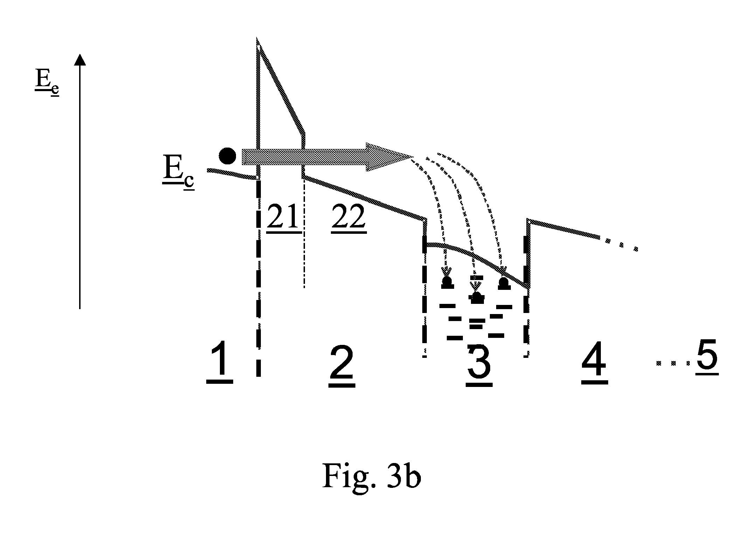

The physical properties of portions 21, 22 of the insulating barrier, such as the dielectric constant and thickness of the materials used to form these portions, are selected such that the electric field over the first portion is stronger than the electric field over the second portion of the insulating barrier. The potential energy profile over the first portion therefore has a stronger voltage dependence than the potential energy profile over the second portion. This is illustrated in figure 3b. As a result, the potential energy profile upon applying a suitable voltage for tunnelling will show a steeper inclination over the first portion than over the second portion. In this way, a lower voltage is required for tunnelling with respect to a prior art single-layer insulating barrier of equal thickness to reduce the energy barrier during tunnelling by the same amount as in the prior art single-layer insulating barrier. Furthermore, as the first portion 21 is substantially thinner than the second portion 22, the potential energy profile during tunnelling comprises a larger part with the more shallow inclination, which implies that the tunnelling voltage can be reduced by a substantial amount with respect to the single-layer insulating barrier. Thus, the power consumption of the non-volatile memory device can be maintained at a low level.

On the other hand, the presence of the thicker second portion 22 of the insulating barrier, whose weaker electric field does not substantially increase the voltage drop over the insulating barrier needed for establishing the tunnelling current, does increase the physical thickness of the insulating barrier 2, thereby providing an additional potential energy barrier for the charge stored in the charge storage medium to tunnel from the charge storage medium 3 towards the charge supply region 1. So the presence of the second portion 22 of the insulating barrier is a first factor that enhances data retention of the non-volatile memory device.

In the non-volatile memory device shown in figure 2, charge carriers are stored in multiple storage sites, isolated from each another, and distributed in energy and space, in the charge storage medium 3. As a result of this distribution, the memory device has high immunity with respect to the presence of a localized defect in the insulating barrier 2. This means that in case of such a localized defect, the charge stored in the discrete storage sites may only leak out of the storage medium locally, due to the storage sites being isolated from each other, as opposed to a conductive storage medium (corresponding to only one big storage site), such as for example the floating gate of alternative embodiments of the invention. In such a conductive storage medium the charge is free to move within the entire storage medium and can completely leak out in time via the localized defect, causing loss of information. On top of this, the spatial distribution of the charge in the storage medium provides an additional barrier, corresponding to the part of the storage medium between a particular storage site and the insulating barrier. This can further improve the ability of such a non-volatile memory to retain stored information for a longer time.

The material of the charge storage medium 3 with discrete storage sites may be chosen from the group comprising: a charge trapping silicon nitride layer, a charge trapping high-k dielectric layer, a silicon-rich oxide, or a dielectric layer embedding small conductive islands isolated from each other. The small conductive islands may be made of Si or Ge nanocrystals. However, the charge storage medium may also be constructed in any other suitable material known to the person skilled in the art.

The control region 5 forms a mechanism for establishing a difference in electrochemical potential over the insulating barrier and for an electric field for tunnelling through the insulating barrier which is adapted for applying an external voltage between the control region and the charge supply region.

As mentioned above, the tunnelling dielectrics in which the first and second portions 21, 22 of the insulating barrier 2 of the non-volatile memory device are constructed may each comprise a single dielectric material. However, the first and second dielectrics 21, 22 may each also comprise a plurality of suitable dielectric materials, which are stacked on top of each other. The tunnelling dielectrics and the thickness of the portions of the insulating barrier 2 are chosen such that the first portion 21 has on average a lower dielectric constant than the second portion 22 such that a major part of the external applied voltage or electrical field drops between the charge storage medium and the charge supply region. Suitable material combinations for the two-layered insulating barrier 2 as shown in the drawings are, for example, Si02, silicon oxynitride such as SiON - typically containing Si, O and N in different ratio's, or Si3N4 for the first portion and Al2O3, Hf02, Hf silicates such as HfSiOx - containing Hf, Si and O in different ratio's, or HfSiON - containing Hf, Si, O, N in different ratio's, Hf Aluminates such as HfAlOx, containing Hf, Al and O in different ratios or Zr02 for the second portion. The second portion 22 can for example be deposited by a technique such as atomic layer chemical vapor deposition (ALCVD), metal-organic chemical vapor deposition (MOCVD), which can easily be achieved, or other method suitable for formation of thin dielectric films. Furthermore, Al2O3, Hf02, Hf silicates, Hf aluminates and Zr02 are high-dielectric constant materials, which are currently considered for use in standard silicon semiconductor technology, for example in the standard CMOS transistor process. As a result, with these materials the insulating barrier 2 can be easily constructed, as the use of additional materials, which are not already used in the normal transistor manufacturing process, can be avoided. Of course, any other material combinations, which are deemed suitable to the person skilled in the art, may also be used in the insulating barrier.

In the embodiment shown in fig. 2, the insulating barrier 2 comprises first and second portions of which the dielectrics are chosen such that, in absence of a voltage difference over the insulating barrier, the first portion 21 has a higher potential energy barrier than the second portion 22 for carriers for which tunnelling is to be blocked. In other words, the energy band diagram of the insulating barrier has a stepped profile with a higher step over the first portion 21 than over the second portion 22. This has the advantage that the tunnelling current through the insulating barrier 2 can be easily controlled by the first portion 21 of the barrier only, when a sufficient part of the external applied voltage drops over the insulating barrier 2. This may enable direct tunnelling through the first portion 21 of the insulating barrier 2 only. This embodiment also has the advantage that the energy band diagram during tunnelling descends monotonously.

In the description of the above paragraphs, no distinction has been made whether the charge carriers tunnelling through the insulating barrier 2 are positive or negative charge carriers. This is because the description applies to both types of charge carriers. However, below the distinction will be made for the sake of simplicity, to describe how the insulating barrier functions in enabling tunnelling of both types of charge carriers from the charge supply region 1 to the charge storage medium 3. Evidently, the words negative and positive are interchangeable.

In the embodiment shown in fig. 2, negative charges, which have been stored in the storage medium 3 by means of the mechanism described above, can efficiently be removed from the discrete storage sites of the storage medium by establishing a tunnelling current of positive charge carriers through the insulating barrier 2 from the charge supply region 1 to the charge storage medium 3. This tunnelling current of positive charge carriers can also be used to trap positive charge in the discrete storage sites of the storage medium 3.

In order to enable the positive tunnelling current, the insulating barrier 2 is adapted at the design stage. The insulating region 2, being the same as before, comprises the first portion 21 contacting the charge supply region 1 and the second portion 22 contacting the first portion and extending towards the charge storage medium 3. In order to achieve the tunnelling current of positive charge carriers, the thickness of the first and second portions and the tunnelling dielectrics are chosen such that upon applying a suitable electric field over the insulating barrier, the potential energy barrier of the second portion 22 is suppressed more than the potential barrier of the first portion 21, or substantially removed, for positive charge carriers. The applied electric field corresponds to a voltage drop over the insulating barrier of opposite polarity compared to the polarity of the voltage drop applied for storing negative charge in the charge storage medium. This voltage drop reduces the potential energy barrier for tunnelling positive charge carriers, and therefore establishes a tunnelling current of positive charge carriers (e.g. holes) through the insulating barrier from the charge supply region 1 to the charge storage medium 3.

Because the adaptation of the insulating barrier 2 does not substantially affect the charge storage medium 3, the insulating barrier 2 can be applied in NVM devices having a charge trapping storage medium as shown in fig. 2 as well as in floating gate NVM devices. There also, the positive tunnelling current can either be used for removing negative charge from the floating gate or storing a positive charge in the floating gate.

In the embodiment shown in fig. 2, the tunnelling dielectrics of the portions 21 and 22 are chosen such that, in absence of an electric field over the insulating barrier, the first portion 21 has a higher potential energy barrier for holes than the second portion 22. The dielectrics are furthermore chosen such that the strength of the electric field and therefore of the voltage drop for tunnelling positive charge through the insulating barrier substantially completely shifts the potential energy of the second portion 22 below the energy level of the positive charge carriers which are to be supplied by the charge supply region. In this way, the energy barrier of the second portion is fully or substantially removed during tunnelling, so that the tunnelling current of positive charges is also mostly determined by direct or Fowler-Nordheim tunnelling of holes through the thin first portion. This is illustrated in fig. 4b.

The electric field for tunnelling positive charge carriers is also established by applying a voltage difference between the charge supply region 1 and the control region 5, which is located on the opposite side of the charge storage medium 3 with respect to the charge supply region 1 and is separated from the charge storage medium 3 by the second insulating barrier 4.

The charge supply region 1 is adapted to provide both types of charge carriers, e.g. electrons and holes. It can be typically realized in a semiconductive material, such as Si, which can be doped with p-type dopants, such as e.g. Boron, or n-type dopants, such as Phosphorus or Arsenic. The charge supply region 1 comprises two regions 11, in the field usually denoted source and drain, schematically shown by the dotted lines in figure 1, which are highly doped with dopants of a type opposite to the dopants of the charge supply region 1 itself. In case of a p-doped charge supply region 1 these regions 11 are of n-type, such as, for example, Si doped with P or As. In the case of an n-doped charge supply region 1 these regions are of p-type, such as, for example, Si doped with B. The doping of the charge supply region 1 can be realized through specific techniques such as ion implantations. Each of the regions 11 is electrically connected to one external electrode 12. The regions 11 act as charge reservoirs for providing charge carriers of opposite type as compared to the charge carriers supplied by body of region 1, when corresponding biases are applied. These regions 11 are also used when determining the amount and type of charge stored in the charge storage medium 3. This sensing can be realized by applying appropriate external voltages between the electrodes 12 connected to the two regions 11 and between the electrodes 12 connected to the control region 5 and the charge supply region 1. This external biasing allows for reading out the current flowing between the regions 11, which current depends for a given external bias on the amount and type of charge stored in the charge storage medium 3 as is known in the art.

The structure 10 of figure 1 is electrically controlled by the region 5, which is separated from the charge storage medium 3 by the second insulating region 4. This control region 5 is electrically contacted by an electrode 12. Hence the charge storage medium 3 is sandwiched between two dielectric regions 2, 4 isolating the charge storage medium 3 from the carrier supply region 1 and the control region 5. The whole structure 10 forms a device with at least four electrodes 12 such that a voltage difference and hence an electrical field can be applied over the insulating barrier 2 for tunnelling charge carriers from the charge supply region 1 to the charge storage medium 3 and for reading out the charge stored in the charge storage medium 3. The charge storage medium 3 can be typically implemented with (i) a charge trapping silicon nitride layer, (ii) a charge trapping high-k dielectric (insulating) layer, (iii) a silicon-rich oxide, (iv) a dielectric (insulating) layer embedding small conductive islands, isolated from each another. These islands can be made for example of Si or Ge nanocrystals, or a conductive material, e.g. a metal, which can accommodate one or more carriers in a narrow spatial region corresponding to a potential energy well. The second insulating barrier 4 can be a silicon oxide layer, such as Si02, thick enough to block efficiently any carrier exchange between the control region 5 and the charge storage medium 3, or can be another insulating material, e.g. a high-k dielectric like aluminum oxides e.g. Al2O3, hafnium oxides e.g. Hf02, hafnium silicates e.g. HfSiOx compounds containing Hf, Si, O in different ratios, or HfSiON compounds containing Hf, Si, O, N in different ratios, hafnium -aluminates e.g. HfAlOx compounds containing Hf, Al, O in different ratios, zirconium oxides, e.g. Zr02. The control region 5 can be any conductive material. Straightforward implementations are highly doped polycrystalline silicon, either of n- or p-type, a metal, or a compound with metallic character such as a metalsilicide, e.g. TiSi2, nickelsilicide, e.g. NiSi, Ni2Si, a conductive metal-nitride, such as TiN or TaN, or a conductive metal-oxide such as, for example, Ru02.

The energy band diagram of fig. 2 shows the potential energy profiles at flatband voltage condition and in the absence of charge stored in any of the dielectric regions 2-3-4 in between the charge supply region 1 and the control region 5, for the bands relevant for both electron transport (e.g. the conduction band, the potential energy profile being given by the bottom of the conduction band, Ec) and hole transport (e.g. the valence band, the potential energy profile being given by the top of the valence band, Ev). The asymmetric insulating barrier 2 is sufficient, since only tunnelling from the charge supply region 1 towards to charge storage medium 3 is required. The asymmetric structure is formed by the first portion 21 which has a low dielectric constant, e.g. below 15, and which neighbors region 1 and the second portion 22 which has a high dielectric constant, e.g. above 7, and which neighbors region 3. The first portion 21 has on average a lower dielectric constant than the second portion 22. The first portion can be a silicon oxide layer, such as Si02, a nitride layer e.g. Si3N4, a silicon oxynitride layer, such as SiON, consisting of Si, O and N in different ratio's or a combination thereof while the second portion can be a high-k dielectric like aluminum-oxides e.g. Al2O3, hafnium oxides e.g. Hf02, hafnium silicates, e.g. HfSiOx, HfSiON, hafnium-aluminates, e.g. HfAlOx, zirconium oxides, e.g. Zr02. The potential energy barrier of the second portion 22 is less than the potential energy barrier of the first portion 21, but in alternative embodiments it could also be substantially the same. For electrons the potential energy barrier of the first portion 21, e.g. the bottom of its conduction band Ec, may be higher than or substantially the same as the potential energy barrier of the second portion 22. For holes the potential energy barrier of the first portion 21, e.g. the top of its valence band Ev, may be higher than or substantially the same as the potential energy barrier of the second portion 22. The charge storage medium 3 has potential energy barriers for both types of charge carriers, e.g. electrons and holes that can be lower (as drawn in figure. 2), higher or substantially the same as the potential energy barriers of the second portion 22 of the insulating barrier 2 for these type of charge carriers. The one or more dielectric materials of the first portion 21 and the one or more dielectric materials of the second portion 22 are chosen such that upon applying an external voltage between the region 5 and the charge supply medium 1 sufficient for tunnelling of carriers between the charge supply region 1 and the charge storage medium 3, the strength of the electrical field over the first portion 21 is greater than the strength of the electrical field over the second portion 22, and this for both types of charge carriers, see fig. 3b and fig. 4b. Furthermore, the thickness of the first portion 21 and the thickness of the second portion 22 are chosen such that upon applying an external voltage between the region 5 and the charge supply medium 1 sufficient for tunnelling of carriers between the charge supply region 1 and the charge storage medium 3, the potential energy barrier of the second portion 22 is suppressed more than the potential energy barrier of the first portion 21, or substantially removed, and this for both types of charge carriers.

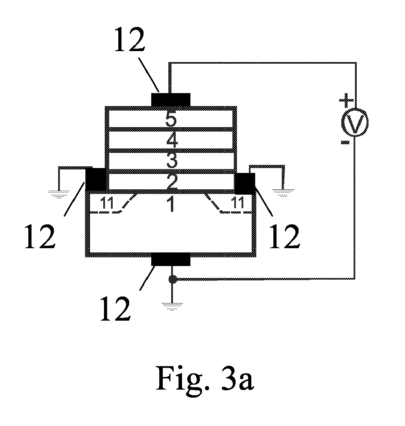

The operation of the embodiment of non-volatile memory device of figures 1 and 2 is illustrated by figures 3 to 6. The two logical states of the device, conventionally defined, are: a logic "1" when sufficient negative charge, e.g. electrons, is transferred to the charge storage medium 3 during the write or program step, and a logic "0" when the charge corresponding to the written state is either removed from the charge storage medium 3 or electrically neutralized by compensation or recombination with charge of opposite polarity, which are holes in case electrons are stored during programming. The logic "0" state is characterized in that it is either electrically neutral, or it has a significantly smaller net negative charge as compared to the logic "1" state, or it can even have a net positive charge, i.e. of opposite polarity as compared to the logic "1" state.

Writing of the memory device is realized by applying a high voltage to the control region 5, sufficient for tunnelling of negative carriers (electrons) in one energy band (conduction band) from the charge supply region 1 through the insulating barrier 2 into the charge storage medium 3. If for example a high positive voltage is applied to control region 5 with respect to the charge supply region 1, electrons will tunnel from the conduction band of the charge supply region 1 to the charge storage medium 3, where they are trapped in the charge storage sites. These electrons can be provided by the portions 11, typically grounded, as minority carriers from the inversion layer formed at the interface between the body of the charge supply region 1 and the insulating barrier 2, if the body of region 1 is p-type doped. Alternatively these electrons can be provided as majority carriers by the body of the charge supply region 1, if this is an n-type doped semiconductor material. The first situation, e.g. electrons as minority carriers, is depicted in figure 3b schematically showing the variation of the potential energy profile for electrons Ec in the non-volatile memory device illustrated by figure 1 whereby a high positive voltage is applied to the control region 5 illustrated by the bias set-up of figure 3a. Typically, a major fraction of the voltage applied over the structure 10 will drop over the regions 2 and 3 and a smaller fraction of this externally applied voltage will drop over the second insulating barrier 4. The charge, indicated by solid circles, is stored at physically separated locations, indicated by the dashes, within the charge storage medium 3. These locations can be charge traps in a dielectric material or allowed energy levels in small conductive regions such as conductive dots or nanocrystals or other. The energy level allowed for charge storage may vary over the charge storage medium 3 from one storage site to another such that the charge storage medium 3 is not necessarily characterized by a single energy level where charge can be stored upon but rather by a distribution of energy levels upon which injected charge can be stored. Furthermore, these physically separated charge storage sites may be spatially distributed across a part of or over the entire volume of the charge storage medium 3 and thus be at variable distance from the charge supply region 1, thus being, as illustrated in figure 3b.

Erasing of the memory device is realized by applying a high voltage to the control region 5 with respect to the supply region 1, but having opposite polarity as compared to the voltage applied to the control region 5 when writing the non-volatile memory device. This high voltage difference must be sufficient for tunnelling of carriers from the charge supply region 1 through the insulating barrier 2 into the charge storage medium 3 in an energy band, other than the energy band for tunnelling of carriers when programming the memory device. The carriers are thus of a polarity opposite to the polarity of carriers tunnelling from the charge supply region 1 to the charge storage medium 3 when writing the non-volatile memory device. If for example a high negative voltage is applied to control region 5 with respect to the charge supply region 1, as illustrated in figure 4a, holes will tunnel form the valence band of the charge supply region 1 to the charge storage medium 3. The holes can be either majority carriers accumulated at the interface between the charge supply region 1 and the insulating barrier 2, in case the charge supply region is implemented with a p-type doped Silicon or can be provided as inversion layer carriers by the p+-doped portions 11, in case the charge supply region is implemented with a n-type doped Silicon. The holes injected into the charge storage medium 3 will totally or partly neutralize the carriers, stored during writing of the non-volatile memory device by compensation or recombination, bringing the non-volatile memory device back to (or close to) its original state, or even to a state of net positive charge. Thus, this erased state is either electrically neutral or substantially different from the written state with respect to net charge stored in the charge storage medium 3. This difference in the net stored charge will result in a substantially different threshold voltage of the non-volatile memory device 10. The non-volatile memory device being in this state, is said to be erased. This situation is depicted in figure 4b schematically showing the variation of the potential energy profile for holes Ev in the non-volatile memory device illustrated by figure 1 whereby a high negative voltage is applied to the control region 5 as illustrated by figure 4a. Typically, a larger fraction of the voltage applied over the structure 10 will drop over the regions 2 and 3 and a smaller fraction of this externally applied voltage will drop over the second insulating barrier 4. The charge carries of opposite polarity, e.g. holes, indicated by open circles, tunnel through the insulating barrier 2 into the charge storage medium 3 where they interact with the electrons, depicted by solid circles, stored therein at physically separated locations, indicated by the dashes. There the holes neutralize or even exceed the electrons by compensation or recombination. The non-volatile memory device is said to be erased. The charge supply region 1 is adapted for supplying sufficient carriers of both polarity types, e.g. electrons and holes. Preferably the charge supply region 1 is a semiconductive material like silicon, silicon-germanium or any other semiconducting material(s) known in the art. The charge supply region 1 can also be realized in another material capable of providing both types of carriers.

The embodiment of the non-volatile memory device as described herein may offer the advantage of combining low write/erase voltages with improved charge retention. The improved charge retention is due to, at least in part:
(i) A larger physical thickness of the insulating barrier 2, a large part of which is given by the second portion 22 of the insulating barrier 2. This larger physical thickness provides an additional tunnelling barrier for the charge stored in the charge storage medium 3.
(ii) An intrinsic built-in effect in the asymmetric insulating barrier 2, which causes the potential energy barrier to be less sensitive to internal electrical potentials generated by the negative charge stored in the charge storage medium 3 during writing. This internal electrical potential will have the same effect as biasing the insulating barrier 2 in a reverse mode which occurs when erasing as opposite to the forward biasing mode, which occurs when programming the non-volatile memory device.

Figure 5 shows a schematic representation of an energy diagram of the non-volatile memory device illustrated by figure 1. This energy band diagram is drawn when no external voltage is applied and when charge is stored in the charge storage medium 3. Arrow (a) illustrates the advantage of better retaining charge stored on the storage sites in the charge storage medium 3 due to the additional physical barrier provided by the high-dielectric constant portion 22 of the region 2. Arrows (b) illustrate the advantage of better retaining charge due to the spatial distribution of the storage sites adding to the physical barrier by the additional distances. The actual shape of the band diagram in the second insulating layer 4 may be different and is function of the implementation of choice. Instead of using a single dielectric material as shown in Figures 2 to 5, multiple dielectric materials can be used to form a stack similar to the dielectric stack used to form the insulating region 2.

The performance of the non-volatile memory device 10 can be further improved if, instead of a semiconductive material as shown in Figures 2 to 5, a material with metallic characteristics and with a predefined workfunction (Wm), with respect to a vacuum is used to form the control gate 5. Alternatively, the second insulating barrier 4 can be a high-k dielectric or a combination of high-k and low-k dielectrics similar to the first insulating barrier 2. The thickness and the materials selected for the second insulating barrier 4 need not be the same as the thickness and the materials selected for the insulating barrier 2. Even the high-k and low-k dielectrics can be arranged in an order different from the order used in the insulating layer 1. Figure 6 shows a schematic representation of a potential barrier diagram of such a non-volatile memory device. This potential energy band diagram is drawn when no external voltage is applied and when charge is stored in the charge storage medium 3. Compared to the non-volatile memory device whose band diagram is shown in figure 5, here the second insulating region 4 consists of two portions 41, 42: a first portion 41 with a low dielectric constant and neighboring control region 5 and a second portion 42 with a high dielectric constant and neighboring charge storage medium 3. The first portion 41 has on average a lower dielectric constant than the second portion 42. The first portion can be a silicon oxide layer, such as Si02, a silicon nitride layer e.g. Si3N4, a silicon oxynitride layer or a combination thereof while the second portion can be a high-k dielectric like aluminum oxides e.g. Al2O3, hafnium oxides e.g. Hf02, hafnium silicates, e.g. HfSiOx, HfSiON, hafnium aluminates, e.g. HfAlOx, zirconium oxides, e.g. Zr02. The control region 5 is formed of a metal or metallic compound having a work function Wm, value of which can be close to the Fermi level of a highly-doped n-type Silicon. i.e. around 4 eV. Furthermore, if the workfunction of this metal is selected to be near midgap of crystalline silicon or near the Fermi level of a highly-doped p-type Silicon, e.g. ranging from about 4.5 to about 5.5 eV, the electron tunnel current from the control region 5 to charge storage medium 3, which might occur due to the high voltage applied during the erase operation, is significantly reduced. This electron current would eventually adversely affect the device performance by erase saturation, as additional negative charge would be injected in the charge storage medium 3 thereby slowing down or even stopping the erase operation. Therefore, using a metal with a high workfunction may even increase the immunity to the erase saturation, improving device functionality.

## Claims

1. A non-volatile memory device comprising a charge supply region (1), a charge storage medium (3), an insulating barrier (2) extending between the charge supply region (1) and the charge storage medium (3), and means (5) for establishing an electric field over the insulating barrier (2) for tunnelling charge carriers from the charge supply region to the charge storage medium (3), the insulating barrier (2) comprising a first portion (21) contacting the charge supply region (1) and a second portion (22) contacting the first portion and extending towards the charge storage medium (3), the first portion (21) being substantially thinner than the second portion (22), the first and second portions being each constructed in one or more tunnelling dielectrics, the tunnelling dielectrics of the first and second portions being chosen such that the first portion (21) has on average a lower dielectric constant than the second portion (22), **characterised in that** the first and second portions have predetermined thicknesses which are determined such that tunnelling of negative as well as positive charge carriers from the charge supply region (1) to the charge storage medium (3) is enabled.

2. A non-volatile memory device according to claim 1, **characterised in that** the thicknesses and the tunnelling dielectrics of the first and second portions (21, 22) are chosen such that upon applying an electric field suitable for tunnelling positive or negative charge carriers through the insulating barrier (2) the applied electric field over the first portion (21) is stronger than the applied electric field over the second portion (22).

3. A non-volatile memory device according to claim 1 or 2, **characterised in that** the thicknesses and the tunnelling dielectrics of the first and second portions (21, 22) are chosen such that upon applying an electric field suitable for tunnelling positive or negative charge carriers through the insulating barrier (2), the potential energy barrier of the second portion (22) for tunnelling carriers is suppressed more than the potential energy barrier of the first portion (21) for tunnelling.

4. A non-volatile memory device according to any one of the claims 1-3, **characterised in that** said electric field establishing means (5) are adapted for applying a voltage drop between the charge supply region
(1) and the charge storage medium (3) and **in that** the tunnelling dielectrics and the thicknesses of the first and second portions (21, 22) are chosen such that, upon applying a voltage drop suitable for tunnelling positive, resp. negative charge carriers through the insulating barrier (2), the potential energy barrier of the second portion (22) for tunnelling positive, resp. negative charge carriers is substantially removed.

5. A non-volatile memory device according to claim 4, **characterised in that** the voltage drop over the first portion (21) is higher than the voltage drop over the second portion (22).

6. A non-volatile memory device according to any one of the claims 1-5, **characterised in that** the charge storage medium (3) is a floating gate.

7. A non-volatile memory device according to any one of the claims 1-5, **characterised in that** the charge storage medium (3) is chosen from the group comprising: a charge trapping silicon nitride layer, a charge trapping high-k dielectric layer, a silicon-rich oxide, a dielectric layer embedding small conductive islands isolated from each other.

8. A non-volatile memory device according to claim 7, **characterised in that** the small conductive islands are made of Si or Ge nanocrystals.

9. A non-volatile memory device according to any one of the previous claims, **characterised in that** the tunnelling dielectrics are chosen such that, in absence of an electric field over the insulating barrier (2), the first portion (21) has a higher potential energy barrier than the second portion (22), for both negative and positive charge carriers tunnelling from the charge supply region (1) to the charge storage medium (3).

10. A non-volatile memory device according to any one of the previous claims, **characterised in that** the insulating barrier is constructed as a two-layered structure, with the dielectrics of the first and the second portions being selected from the group comprising: Si02, silicon oxynitride, e.g. SiON, or Si3N4, Al2O3, Hf02, Hf silicate, e.g. HfSiOx or HfSiON, Hf aluminate, e.g. HfAlOx, Zr02, Pr2O3, Y2O3, La2O3 or La-aluminate, e.g. LaAlO.

11. A non-volatile memory device according to any one of the claims 1-10, **characterised in that** the insulating barrier is constructed as a two-layered structure, with the first portion (21) being constructed in a dielectric material with a dielectric constant lower than 15, and the second portion (22) being constructed in a dielectric material with a dielectric constant higher than 7.

12. A non-volatile memory device according to any one of the previous claims, **characterised in that** the means for establishing a tunnelling current comprise a control region (5) which is located on the opposite side of the charge storage medium (3) with respect to the charge supply region (1) and is separated from the charge storage medium (3) by a second insulating barrier (4).

13. A non-volatile memory device according to claim 12, **characterised in that** the second insulating barrier (4) has a predetermined thickness for blocking charge carrier transfer between the control region (5) and the charge storage medium (3).

14. A non-volatile memory device according to claim 12 or 13, **characterised in that** the second insulating barrier is constructed in Si02, Si3N4, Al2O3, Hf02, Hf-silicate, or Hf-aluminate, or a combination of these materials.

15. A non-volatile memory device according to any one of the claims 12-14, **characterised in that** the control region is constructed in highly doped poly-Si, a metal, or a compound with metallic character.

16. A non-volatile memory device according to claim 15, **characterised in that** the metal or the compound with metallic character has a work function of 4 eV or higher.

17. A non-volatile memory device comprising a charge supply region (1), a charge storage medium (3) comprising discrete storage sites isolated from each other, an insulating barrier (2) extending between the charge supply region (1) and the charge storage medium (3), and means (5) for establishing an electric field over the insulating barrier (2) for tunnelling charge carriers from the charge supply region to the charge storage medium (3), the insulating barrier (2) comprising a first portion contacting the charge supply region (1) and a second portion contacting the first portion and extending towards the charge storage medium (3), the first portion being substantially thinner than the second portion, the first and second portions being each constructed in one or more tunnelling dielectrics, the tunnelling dielectrics of the first and second portions being chosen such that the first portion has on average a lower dielectric constant than the second portion, **characterised in that** the discrete storage sites are located at variable distances from the charge supply region (1), so that they are spatially distributed over at least part of the charge storage medium (3).

18. A non-volatile memory device according to claim 17, **characterised in that** the thicknesses and the tunnelling dielectrics of the first and second portions (21, 22) are chosen such that upon applying an electric field suitable for tunnelling positive or negative charge carriers through the insulating barrier (2) the applied electric field over the first portion (21) is stronger than the applied electric field over the second portion (22).

19. A non-volatile memory device according to claim 17 or 18, **characterised in that** the thicknesses and the tunnelling dielectrics of the first and second portions (21, 22) are chosen such that upon applying an electric field suitable for tunnelling positive or negative charge carriers through the insulating barrier (2), the potential energy barrier of the second portion (22) for tunnelling carriers is suppressed more than the potential energy barrier of the first portion (21) for tunnelling.

20. A non-volatile memory device according to any one of the claims 17-19, **characterised in that** said electric field establishing means (5) are adapted for applying a voltage drop between the charge supply region (1) and the charge storage medium (3) and **in that** the tunnelling dielectrics and the thicknesses of the first and second portions (21, 22) are chosen such that, upon applying a voltage drop suitable for tunnelling positive, resp. negative charge carriers through the insulating barrier (2), the potential energy barrier of the second portion (22) for tunnelling positive, resp. negative charge carriers is substantially removed.

21. A non-volatile memory device according to claim 20, **characterised in that** the voltage drop over the first portion (21) is higher than the voltage drop over the second portion (22).

22. A non-volatile memory device according to any one of the claims 17-21, **characterised in that** the charge storage medium (3) is chosen from the group comprising: a charge trapping silicon nitride layer, a charge trapping high-k dielectric layer, a silicon-rich oxide, a dielectric layer embedding small conductive islands isolated from each other.

23. A non-volatile memory device according to claim 22, **characterised in that** the small conductive islands are made of Si or Ge nanocrystals.

24. A non-volatile memory device according to any one of the claims 17-23, **characterised in that** the tunnelling dielectrics are chosen such that, in absence of an electric field over the insulating barrier (2), the first portion (21) has a higher potential energy barrier than the second portion (22), for both negative and positive charge carriers tunnelling from the charge supply region (1) to the charge storage medium (3).

25. A non-volatile memory device according to any one of the claims 17-24, **characterised in that** the insulating barrier is constructed as a two-layered structure, with the dielectrics of the first and the second portions being selected from the group comprising: Si02, silicon oxynitride, e.g. SiON, or Si3N4, A1203, Hf02, Hf silicate, e.g. HfSiOx or HfSiON, Hf aluminate, e.g. HfAlOx, Zr02, Pr2O3, Y2O3, La2O3 or La-aluminate, e.g. LaAlO.

26. A non-volatile memory device according to any one of the claims 17-25, **characterised in that** the insulating barrier is constructed as a two-layered structure, with the first portion (21) being constructed in a dielectric material with a dielectric constant lower than 15, and the second portion (22) being constructed in a dielectric material with a dielectric constant higher than 7.

27. A non-volatile memory device according to any one of the claims 17-26, **characterised in that** the means for establishing a tunnelling current comprise a control region (5) which is located on the opposite side of the charge storage medium (3) with respect to the charge supply region (1) and is separated from the charge storage medium (3) by a second insulating barrier (4).

28. A non-volatile memory device according to claim 27, **characterised in that** the second insulating barrier (4) has a predetermined thickness for blocking charge carrier transfer between the control region (5) and the charge storage medium (3).

29. A non-volatile memory device according to claim 27 or 28, **characterised in that** the second insulating barrier is constructed in Si02, Si3N4, Al2O3, HfO2, Hf-silicate, or Hf-aluminate, or a combination of these materials.

30. A non-volatile memory device according to any one of the claims 27-29, **characterised in that** the control region is constructed in highly doped poly-Si, a metal, or a compound with metallic character.

31. A non-volatile memory device according to claim 30, **characterised in that** the metal or the compound with metallic character has a work function of 4 eV or higher.
